Europäisches Patentamt

European Patent Office

Office européen des brevets

(19)

(11) Veröffentlichungsnummer: **0 198 383**
**A2**

# EUROPÄISCHE PATENTANMELDUNG

(12)

(21) Anmeldenummer: 86104724.9

(22) Anmeldetag: 07.04.86

(51) Int. Cl.⁴: **H01L 21/82** , H01L 27/08

(30) Priorität: 08.04.85 US 721257

(43) Veröffentlichungstag der Anmeldung:
22.10.86 Patentblatt 86/43

(84) Benannte Vertragsstaaten:
DE FR GB

(71) Anmelder: **Siemens Aktiengesellschaft Berlin
und München**
**Wittelsbacherplatz 2**
**D-8000 München 2(DE)**

(72) Erfinder: **Shieh, Chang-Long, Dr.**
**24 Linden Lane South**
**Plainsboro, NJ 08536(US)**

(54) **Verfahren zur Herstellung einer Halbleiteranordnung für die integrierte Injektionslogik und nach diesem Verfahren hergestellte Halbleiteranordung.**

(57) Es wird ein Verfahren zur Herstellung einer Halbleiteranordnung für die integrierte Injektionslogik angegeben, wobei mit Vorteil ein Substrat (A) aus einer III-V-Halbleiterverbindung benutzt wird. Ein lateraler Transistor (L) kann mit einem Basisbereich ausgebildet werden, dessen Breite extrem klein ist - (unter 0,1 μm), wenn Aufwachstechniken (regrowth techniques) angewendet werden. Ein vertikaler Transistor (V) kann durch Verwendung eines Schottky-Kollektors (J) in sehr einfacher Weise hinzugefügt werden.

## FIG 1

EP 0 198 383 A2

# Verfahren zur Herstellung einer Halbleiteranordnung für die integrierte Injektionslogik und nach diesem Verfahren hergestellte Halbleiteranordnung

Die Erfindung bezieht sich auf ein Verfahren zur Herstellung einer Halbleiteranordnung für die integrierte Injektionslogik nach dem Oberbegriff des Patentanspruchs 1 und auf nach diesem hergestellte Halbleiteranordnungen.

Die als integrierte Injektionslogik (I²L) bezeichnete Schaltungstechnik ist sehr mehr als zehn Jahren bekannt. Monolithisch integrierte Halbleiterschaltungen, die aus bipolaren Transistoren bestehen und in I²L-Technologie aufgebaut sind, haben die Vorteile einer hohen Schaltgeschwindigkeit, eines kleines Leistungsverbrauchs und einer hohen Packungsdichte. Dabei wird die hohe Packungsdichte dadurch erzielt, daß Transistoren verwendet werden, die einen gemeinsamen Emitter im unteren Teil der Halbleiteranordnung aufweisen, so daß Isolierungsmaßnahmen entfallen können. I²L-Schaltungen auf Siliziumbasis werden nunmehr für VLSI-Anwendungen häufig benutzt.

Die Schaltgeschwindigkeit von Silizium-Halbleiteranordnungen ist durch die lange Lebensdauer der Minoritätsladungsträger im Silizium und die niedrige Emitter-Effizienz begrenzt, die sich aus dem Dotierungsprofil ergibt. Die Trägerlebensdauer in III-V-Halbleiterverbindungen ist jedoch üblicherweise kürzer und die Emitter-Effizienz kann unabhängig vom Dotierungsprofil durch die Verwendung von Emittern mit Heteroübergängen verbessert werden, d.h. von Emittern, die PN-Übergänge zwischen unterschiedlichen Materialien aufweisen. Daher sind III-V-Halbleiterverbindungen ideale Materialien für das Implementieren von I²L-Schaltungen. III-V-Halbleiterverbindungen haben die weiteren Vorteile, daß sie eine große Ladungsträgerbeweglichkeit gewährleisten und die Bildung von abgestuften Energieband-Abständen erlauben, um die Übertragungszeit zu reduzieren. Daher ist die I²L-Schaltungstechnik auf der Basis von III-V-Halbleiterverbindungen eine vielversprechende Technologie für Hochgeschwindigkeits-VLSI-Anordnungen.

Die Herstellung von I²L-Schaltungen auf der Basis von III-V-Halbleiterverbindungen wird jedoch dadurch beeinträchtigt, daß es schwierig ist, einen lateralen Transistor vorzusehen. Die Diffusionslänge von Minoritätsladungsträgern in einer III-V-Halbleiterverbindung ist sehr kurz (kleiner als 1 μm). Da die Basisbreite des lateralen Transistors kleiner sein muß als diese Diffusionslänge, ist die Definition des Basisbereiches eines lateralen Transistors durch Lithografie (Diffusion) für die Praxis fast bedeutungslos.

Die Verwendung von III-V-Halbleiterverbindungen bei der Realisierung von I²L-Schaltungen führt zu Schwierigkeiten, wenn es darum geht, ohmsche Anschlußkontakte zu den verschiedenen Schichten herzustellen, die sich im Inneren der Halbleiterstruktur befinden. Da die verschiedenen Schichten der I²L-Struktur sehr dünn sein müssen, um eine hohe Schaltgeschwindigkeit zu erreichen, wird es - schwierig, hierbei gute ohmsche Kontakte zu ausgesuchten einzelnen Schichten herzustellen. Die DE-A-2 509 530 zeigt verschiedene Typen von I²L-Transistorstrukturen. Dabei lassen die Figuren 10A und 10B einen vertikalen oder sog. "invertierten" Transistor erkennen, der mit einem Schottky-Kollektor versehen ist. Durch die Verwendung eines Schottky-Übergangs (Metall-Halbleiter-Übergang) soll hierbei ein eigener Dotierungsschritt für den Kollektor eingespart werden. In der britischen Patentschrift 1 528 029 ist eine I²L-Halbleiteranordnung beschrieben, die aus einem lateralen PNP-Transistor und einem vertikalen NPN-Transistor besteht. Der Injektor-Bereich und der Basisbereich des PNP-Transistors werden durch eine doppelte Diffusion gebildet, so daß der Basisbereich eine im wesentliche gleichmäßige, aber kleine Breite erhält. Wie schon weiter oben erwähnt, ist die Herstellung des Basisbereiches in einer III-V-Halbleiterverbindung mittels einer Diffusion für die Praxis kaum von Bedeutung, da die Basisbreite kleiner als 1 μm sein muß.

Der Erfindung liegt daher die Aufgabe zugrunde, ein Verfahren zur Herstellung von Transistoren für Schaltungen der integrierten Injektionslogik in einer III-V-Halbleiterverbindung anzugeben, das die Bildung eines dünnen und gleichmäßigen Basisbereichs für einen lateralen Transistor erlaubt. Diese Aufgabe wird erfindungsgemäß durch eine Ausgestaltung des Verfahrens nach dem kennzeichnenden Teil des Patentanspruchs 1 erreicht.

Ein Vorteil des Verfahrens nach der Erfindung liegt darin, daß ein dünnes und gleichmäßiges Basisgebiet für einen lateralen Transistor auf einfache Weise gebildet wird. Ein weiterer Vorteil ist darin zu sehen, daß das erfindungsgemäße Verfahren die Bildung von einwandfreien ohmschen Anschlußkontakten für unterschiedliche Schichten der Halbleiterstruktur wesentlich erleichtert. Diese und weitere in der Beschreibung genannten Vorteile werden gemäß der Erfindung durch die Anwendung von Aufwachs-Techniken (regrowth techniques) bei der Bildung einer lateralen Transistorstruktur erreicht.

Anspruch 2 ist auf eine Weiterbildung des Verfahrens nach der Erfindung gerichtet. Nach dieser wird die Herstellung von Transistoren in I²L-Konfiguration durch die Verwendung eines Schottky-Kollektors für den vertikalen Transistor weiter vereinfacht.

Die Ansprüche 3 bis 8 betreffen I²L-Halbleiterstrukturen, die nach den Verfahren der Ansprüche 1 oder 2 hergestellt sind.

Obwohl die Anwendung von Aufwachs-Techniken und Schottky-Kollektoren bei der Herstellung von Halbleiterschaltungen an sich zum Stand der Technik gehört, wird im Rahmen der Erfindung hiervon Gebrauch gemacht, um insbesondere eine neue I²L-Halbleiterstruktur herzustellen. Ein besonderer Vorteil der Aufwachstechniken liegt in diesem Zusammenhang darin, daß sie die Bildung des Basisgebiets des lateralen Transistors mit einer sehr schmalen Breite, z.B. unter 0,1 μm, erlauben.

Die Erfindung wird nachfolgend anhand einiger bevorzugter Ausführungsbeispiele und der beigefügten Zeichnung näher erläutert. Dabei zeigen:

Fig. 1 den Querschnitt einer erfindungsgemäßen I²L-Halbleiterstruktur und

Fig. 2a bis 2f Querschnittsdarstellungen, die einzelne Schritte bei der Herstellung einer erfindungsgemäßen I²L-Halbleiterstruktur verdeutlichen.

In den Figuren sind jeweils identische Elemente mit den gleichen Bezugszeichen versehen.

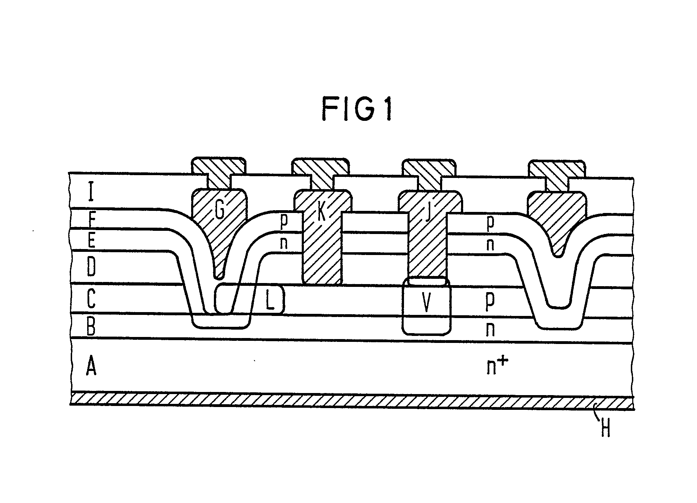

In Fig. 1 ist die vollständige Struktur eines nach der Erfindung ausgebildeten I²L-Schaltkreises dargestellt.

Zwei bipolare Transistoren bilden den I²L-Schaltkreis: Ein lateraler pnp-Transistor, der durch eine ausgezogene Linie angedeutet ist, die eine Fläche L umgibt, und ein vertikaler npn-Transistor, der durch eine ausgezogene Linie angedeutet ist, die eine Fläche V umgibt. In Abweichung hiervon kann es sich auch um einen lateralen npn-und einen vertikalen pnp-Transistor handeln. Jede dieser beiden Transistorkombinationen kann für diesen Schaltkreis benutzt werden. Der vertikale Transistor V besteht aus Schichten B und C und einem Teil J, wobei B den Emitter, C die Basis und J einen Schottky-Kollektor darstellen. Der laterale Transistor L besteht aus Schichten F, E, C, wobei F den Emitter, E die Basis und C den Kollektor bezeichnen.

Die Polaritäten der Schichten B und E sollten mit der des Substrats A übereinstimmen. Die Polaritäten der Schichten C und F sollten zu der des Substrats A entgegengesetzt sein. Die Energieband-Abstände aller dieser Schichten können entweder einheitlich oder gegeneinander abgestuft sein. Zur Vergrößerung der Schaltgeschwindigkeit sollten die Energieband-Abstände der Schichten B und C in aufsteigender Richtung kleiner werden. Um das Konzept des Heteroübergangs-Emitters und der Ladungsträgereinschränkung auszunutzen, sollte der Energieband-Abstand der Schicht B größer sein als der der Schichten C und E . Der Energieband-Abstand der Schicht F sollte größer sein als der der Schicht E. Der Energieband-Abstand von E sollte größer sein als der der Schicht C, wie anhand der weiter unten behandelten Ausführungsbeispiele erläutert werden soll.

Zur Herstellung der erfindungsgemäßen Halbleiteranordnung wird vorzugsweise eine III-V-Halbleiterverbindung, z.B. Galliumarsenid (GaAs) als Substrat A benutzt. Auf diesem werden zwei Epitaxialschichten B und C nacheinander aufgewachsen, wobei B und C dieselbe Polarität haben wie das Substrat. Eine Schicht D aus isolierendem Material wird sodann abgeschieden und strukturiert. Die Schicht D wird als eine Ätzmaske für die Halbleiterschicht C benutzt. Zwei epitaxiale Halbleiterschichten E und F werden sodann auf den Schichten B, C und D aufgebracht. Dieses Vorgehen ist unter unter der Bezeichnung "regrowth"-Technologie bekannt. Das Material, das oberhalb der isolierenden Schicht D aufgebracht worden ist, wirkt halbisolierend, weil es polykristallin ist.

Die Epitaxialschichten B und C und das Aufwachsen der Schichten E und F kann unter Verwendung von herkömmlichen Epitaxie-Technologien erfolgen, so z.B. mittels MBE (molecular beam epitaxy), LPE (liquid phase epitaxy), VPE (vapor phase epitaxy) und/oder MOCVD (metal organic chemical vapor deposition).

Zur Herstellung des I²L-Schaltkreises müssen die folgenden Schichten gemäß Figur 1 mit Anschlußkontakten versehen werden: Die Schichten F und C mit ohmschen Anschlußkontakten G und K und die Schicht C mit einem Schottky-Kontakt J.

Da die Teile der Schichten F und E, die oberhalb der isolierenden Schicht D liegen, halbisolierend sind, bewirken sie eine Isolation der Transistoranordnung.

Die Anschlußkontakte für die Transistoren werden wie folgt hergestellt: Für den ohmschen Anschlußkontakt der Schicht C wird ein Kontaktloch durch die isolierenden Schichten F und E geätzt. Nach dem Strukturieren werden ohmsche Anschlußkontakte G und K jeweils gleichzeitig auf den Schichten F und C aufgebracht. Sodann wird der ohmsche Anschlußkontakt H auf der Rückseite des Substrats aufgebracht, um den gemeinsamen Emitter anschließen zu können. Eine isolierende Schicht I wird ganz oben aufgebracht und so strukturiert, daß ein Kontaktloch für den Schottky-Kontakt der Schicht C und Kontaktlöcher für die Anschlußkontakte G und K entstehen. Anschließend wird das Schottky-Metall J aufgebracht und strukturiert, um die erforderlichen Verbindungen zu erhalten.

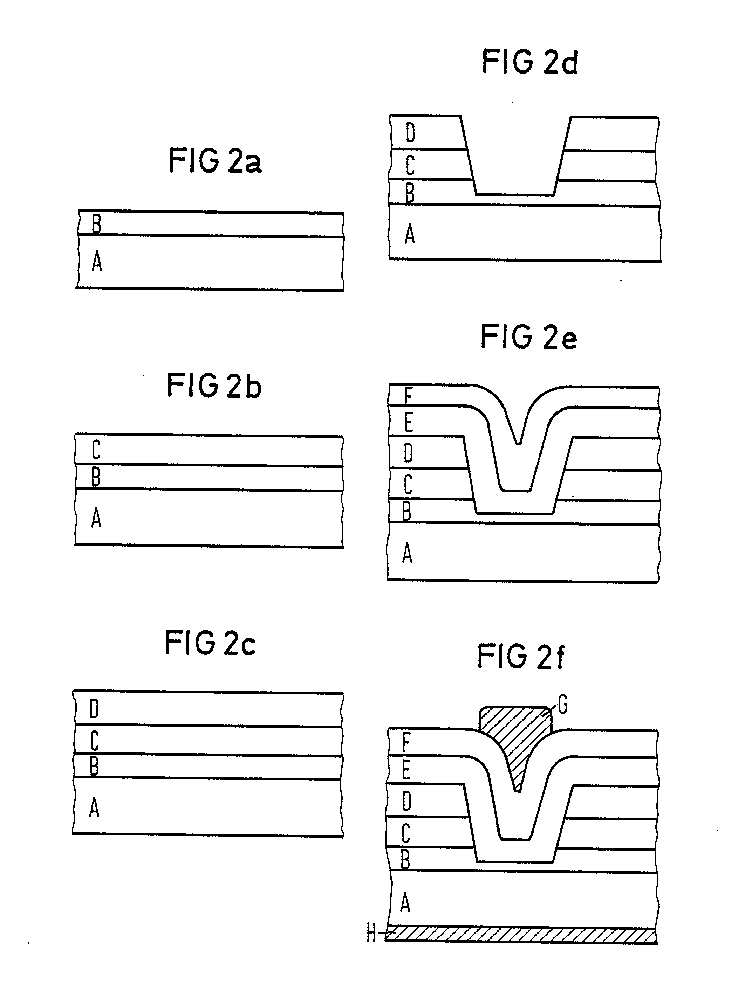

Die Verfahrensschritte zur Herstellung des lateralen Transistors werden anhand der Figuren 2A bis 2F erläutert. Fig. 2A zeigt ein Substrat A, das aus Galliumarsenid mit einer $n^+$-Leitfähigkeit bestehen kann. Dieses trägt eine n-leitende Epitaxialschicht B. Anschließend wird eine erste Epitaxialschicht C des entgegengesetzten Leitfähigkeitstyps (p) auf dem Substrat A und der Schicht B aufgewachsen (Fig. 2B). Gemäß Figur 2 C wird eine isolierende Schicht D, z.B. aus Siliziumnitrid, auf der Schicht C aufgebrcht.

Die isolierende Schicht D wird beim Ätzen der Halbleiterstruktur als eine Ätzmaske benutzt. Fig. 2D läßt erkennen, daß ein Fenster in der Schicht D dazu benutzt wird, um in die Schichten C und B eine Ausnehmung zu ätzen. Anschließend werden Schichten E und F, die jeweils den ersten und zweiten Leitfähigkeitstyp aufweisen, epitaktisch im Bereich der Ausnehmung und auf der isolierenden Schicht D aufgewachsen. Das Material, das auf der isolierenden Schicht aufgewachsen wird, ist polykristallin und daher halbisolierend.

Schließlich wird gemäß 2F ein ohmsches Kontaktmetall G in den Graben eingebracht, der von den Schichten E und F gebildet wird, um den Emitter des lateralen Transistors zu kontaktieren. Außerdem wird ohmsches Kontaktmetall H auch auf der gegenüberliegenden Seite des Substrats A aufgebracht, um die Basis dieses Transistors zu kontaktieren. Der Schottky-Kontakt des vertikalen Transistors kann hergestellt werden, indem die Schichten F, E und D mit einem Kontaktloch versehen werden, das bis zur Schicht C reicht. Das Ätzmittel, das zur Bildung dieses Kontaktloches verwendet wird und das beispielsweise aus Freon 14 ($CF_4$) besteht, wird die Schicht C nicht wesentlich beeinflussen, da es hauptsächlich die Schicht D aus Siliziumnitrid angreift, nicht aber die Galliumarsenidschicht C.

Im folgenden werden vier Ausführungsbeispiele einer erfindungsgemäßen Halbleiterstruktur angegeben:

(1) Vertikaler npn-und lateraler pnp-Transistor mit einheitlichem Energieband-Abstand der Basis. Die Zusammensetzung der einzelnen Schichten ist wie folgt:

A = $n^+$-GaAs-Substrat

B = $n-A_{0.3}Ga_{0.7}As$

C = p-GaAs

D = $Si_3N_4$

E = $n-Al_{0.1},Ga_{0.9}As$

F = $p^+-Al_{0.3}Ga_{0.7}As$

G = Au: Be/Ti/Pt/Au

H = Au: Ge/Ni/Ti/Pt/Au

I = $Si_3N_4$

J = Ti/Pt/Au

(2) Vertikaler pnp-und lateraler npn-Transistor mit gleichförmiger Basis-Zusammensetzung:

A = $p^+$-GaAs-Substrat

B = $p-Al_{0.3}Ga_{0.7}As$

C = n-GaAs

D = $Si_3N_4$

E = $p-Al_{0.1}Ga_{0.9}As$

F = $n^+-Al_{0.3}Ga_{0.7}As$

G = Au: Ge/Ni/Ti/Pt/Au

H = Au: Be/Ti/Pt/Au

I = Ti/Pt/Au.

(3) Vertikaler npn-und lateraler pnp-Transistor mit abgestufen Energieband-Abständen der Basis:

A = $n^+$-GaAs-Substrat

B = $n-Al_{0.3}Ga_{0.7}As$

C = abgestuft von $p-Al_{0.1}Ga_{0.9}As$ (unterer Rand) bis p-GaAs (oberer Rand)

D = $Si_3N_4$

E = abgestuft von $n-Al_{0.1}Ga_{0.9}As$ (unterer Rand) bis $n-Al_{0.2}Ga_{0.8}As$ (oberer Rand)

F = $p^+-Al_{0.3}Ga_{0.7}As$

G = Au: Be/Ti/Pt/Au

H = Au: Ge/Ni/Ti/Pt/Au

I = $Si_3N_4$

J = Ti/Pt/Au

(4) Vertikaler pnp-und lateraler npn-Transistor mit abgestuften Energieband-Abständen der Basis:

A = $p^+$-GaAs-Substrat

B = p-Al$_{0.3}$Ga$_{0.7}$As

C = abgestuft von n-Al$_{0.1}$Ga$_{0.9}$As (unterer Rand) bis n-GaAs (oberer Rand)

D = $Si_3N_4$

E = abgestuft von p-Al$_{0.1}$Ga$_{0.9}$As (unterer Rand) bis p-Al$_{0.2}$Ga$_{0.8}$As (oberer Rand)

F = $n^+$-Al$_{0.3}$Ga$_{0.2}$As

G = Au: Ge/Ni/Ti/Pt/Au

H = Au: Be/Ti/Pt/Au

I = $Si_3N_4$

J = Ti/Pt/Au.

**Ansprüche**

1. Verfahren zur Herstellung einer Halbleiteranordnung für die integrierte Injektionslogik, **dadurch gekennzeichnet, daß**

a) auf einem Substrat (A) eines ersten Leitfähigkeitstyps eine erste Epitaxialschicht - (B) des ersten Leitfähigkeitstyps aufgewachsen wird,

b) eine zweite Epitaxialschicht (C) eines zweiten, zu dem ersten entgegengesetzten Leitfähigkeitstyps auf der ersten Epitaxialschicht (B) aufgewachsen wird,

c) eine isolierende Schicht (B) auf der zweiten Epitaxialschicht (C) aufgebracht wird,

d) eine Ausnehmung in die zweite Epitaxialschicht (C) und in die isolierende Schicht (D) geätzt wird, die sich bis zur ersten Epitaxialschicht (B) erstreckt,

e) eine dritte Epitaxialschicht (E) des ersten Leitfähigkeitstyps im Bereich der Ausnehmung aufgewachsen wird,

f) eine vierte Epitaxialschicht (F) des zweiten Leitfähigkeitstyps auf der dritten Epitaxialschicht im Bereich der Ausnehmung aufgewachsen wird,

g) ein erstes Kontaktloch in die vierte (F) und dritte Epitaxialschicht (E) und in die isolierende Schicht (D) geätzt wird, das sich bis zur zweiten Epitaxialschicht (C) erstreckt,

h) die vierte Epitaxialschicht (F) im Bereich der Ausnehmung mit einem ersten ohmschen Kontakt (G) versehen wird, der den aus einem Teil der vierten Epitaxialschicht (F) gebildeten Emitter eines lateralen Transistors (L) kontaktiert, wobei die zweite Epitaxialschicht (C) durch das erste Kontaktloch mit einem zweiten ohmschen Kontakt (K) versehen wird, der den aus einem Teil der zweiten Epitaxialschicht - (C) gebildeten Kollektor des lateralen Transistors (L) kontaktiert, und

i) ein dritter ohmscher Kontakt (H) auf der entgegengesetzten Seite des Substrats (A) vorgesehen wird, der die durch einen Teil der dritten Epitaxialschicht (E) gebildete Basis des lateralen Transistors (L) kontaktiert.

2. Verfahren nach Anspruch 1, **dadurch gekennzeichnet**, daß in die isolierende Schicht (D), in die dritte Epitaxialschicht (E) und in die vierte Epitaxialschicht (F) ein zweites Kontaktloch geätzt wird, daß sich bis zur zweiten Epitaxialschicht (C) erstreckt und daß ein Schottky-Kontaktmetall in das zweite Kontaktloch eingebracht wird, das einen Schottky-Kollektor eines vertikalen Transistors (V) bildet, dessen Emitter aus einem Teil der ersten Epitaxialschicht (B) und dessen Basis aus einem Teil der zweiten Epitaxialschicht (C) besteht.

3. Halbleiteranordnung für die integrierte Injektionslogik mit einem lateralen Transistor, **gekennzeichnet durch**

ein Substrat (A) eines ersten Leitfähigkeitstyps, eine auf diesem aufgewachsene erste Epitaxialschicht (B) des ersten Leitfähigkeitstyps,

eine zweite Epitaxialschicht (C) eines zweiten, zu dem ersten entgegengesetzten Leitfähigkeitstyps, die auf der ersten Epitaxialschicht (B) aufgewachsen ist,

eine isolierende Schicht (D) auf der zweiten Epitaxialschicht (C),

eine Ausnehmung in der zweiten Epitaxialschicht - (C) und der isolierenden Schicht (D), die sich bis zur ersten Epitaxialschicht (B) erstreckt,

eine dritte Epitaxialschicht (E) des ersten Leitfähigkeitstyps, die im Bereich der Ausnehmung aufgewachsen ist,

eine vierte Epitaxialschicht (F) des zweiten Leitfähig keitstyps, die im Bereich der Ausnehmung auf der dritten Epitaxialschicht (E) aufgewachsen ist,

ein erstes Kontaktloch in der vierten (F) und dritten Epitaxialschicht (E) und in der isolierenden Schicht (D), das sich bis zur zweiten Epitaxialschicht (C) erstreckt,

einen ersten ohmschen Kontakt (G), der einen im Bereich der Ausnehmung liegenden Teil der vierten Epitaxialschicht (F), der den Emitter des lateralen Transistors (L) darstellt, kontaktiert,

einen zweiten ohmschen Kontakt (K), der einen den Kollektor des lateralen Transistors (L) darstellenden Teil der zweiten Epitaxialschicht (C) im Bereich des ersten Kontaktlochs kontaktiert, und

einen dritten ohmschen Kontakt (H) auf der entgegengesetzten Seite des Substrats (A), der die durch einen Teil der dritten Epitaxialschicht (E) gebildete Basis des lateralen Transistors (L) kontaktiert.

4. Halbleiteranordnung nach Anspruch 3, **gekennzeichnet durch** ein zweites Kontaktloch in der vierten (F) und dritten Epitaxialschicht (E) und in der isolierenden Schicht (D), das sich bis zur zweiten Epitaxialschicht (C) erstreckt und durch einen Schottky-Kontakt (J), der die zweite Epitaxialschicht (C) im Bereich des zweiten Kontaktloches kontaktiert, wobei ein Teil der ersten Epitaxialschicht (B) den Emitter, ein Teil der zweiten Epitaxialschicht - (C) die Basis und der Schottky-Kontakt (J) den Schottky-Kollektor eines vertikalen Transistors (V) bilden.

5. Halbleiteranordnung nach Anspruch 3 oder 4, **dadurch gekennzeichnet,** daß das Substrat aus einer III-V-Halbleiterverbindung besteht.

6. Halbleiteranordnung nach einem der Ansprüche 3 bis 5, **dadurch gekennzeichnet,** daß die Dicke der dritten Epitaxialschicht (E) kleiner ist als 0,1 μm.

7. Halbleiteranordnung nach einem der Ansprüche 3 bis 6, **dadurch gekennzeichnet,** daß die dritte Epitaxialschicht (E) abgestufte Energieband-Abstände aufweist.

8. Halbleiteranordnung nach einem der Ansprüche 3 bis 7, **dadurch gekennzeichnet,** daß der erste Leitfähigkeitstyp eine n-Leitfähigkeit und der zweite Leitfähigkeitstyp eine p-Leitfähigkeit bestimmen.

# FIG 1

I

F
E
D
C
B
A

G    p
     n

K

L

J    V

p
n

p

n

n+

H

FIG 2a

FIG 2b

FIG 2c

FIG 2d

FIG 2e

FIG 2f